# EUROPEAN PATENT APPLICATION

(11) **EP 1 035 423 A2**
(43) Date of publication of application: **13.09.2000**
(21) Application number: 00301231.7
(22) Date of filing: 17.02.2000
(51) Int. Cl.: G02B 3/00, H01S 5/026, H01S 5/183

(54) **Micro-lens, combination micro-lens and vertical cavity surface emitting laser, and methods for manufacturing the same**

(30) Priority: 19.02.1999 KR 9905513; 03.02.2000 KR 0005485; 20.01.2000 KR 0002604
(71) Applicant: SAMSUNG ELECTRONICS CO., LTD., Suwon-City, Kyungki-do (KR)
(72) Inventor: Lee, Jeong-kwan, Dongan-gu, Anyand-city, Kyungki-do (KR); Jeong, Heon-su, Kunpo-city, Kyungki-do (KR); Shin, Hyun-kuk, Paldal-gu, Suwon-city, Kyungki-do (KR)
(74) Representative: Robinson, Ian Michael

(57) **Abstract**

A micro-lens formed by etching a semiconductor member (10) in a chemical etching solution, which contains an etchant causing diffusion-limited etching to the semiconductor, using an etching mask (20) having an opening (h) defining a portion of the semiconductor member to be a convex surface of the micro-lens. Also disclosed is a combination micro-lens and vertical cavity surface emitting layer (VCSEL) in which a micro-lens is formed at a window region of a laser emitting surface by the diffusion-limited etching.

## Description

The present invention relates to a micro-lens, a combination micro-lens and vertical cavity surface emitting laser (VCSEL), and methods for manufacturing the same, and more particularly, to a micro-lens and a method for manufacturing the same, in which the micro-lens is formed on a semiconductor substrate by wet chemical etching, and a combination micro-lens and VCSEL and a method for manufacturing the same, in which a micro-lens is formed at a light emitting surface of a VCSEL so that a laser beam can be condensed by and emitted through the micro-lens without need for a separate condensing lens.

Recently, in the optical communications system field, interest has been increasing in lens systems for use in micro-light devices. In particular, research into a convenient method for manufacturing small lens systems and an efficient technique for coupling a micro-lens and a micro-light device are actively being conducted.

For example, in Electronics Letters Vol. 24(2), pp. 109-110, January, 1988, a technique for integrating and manufacturing a micro-lens on the surface of a GaInAs/InP photo diode has been proposed. According to this technique, a photoresist mask is used to define a micro-lens area on a substrate, and an argon (Ar) ion beam etching technique is adopted to shape the lens.

However, the problem with this technique is contamination of a vacuum chamber by a high-concentration of Ar ions therein which hits the photoresist mask during etching. In addition, the technique can only be implemented through multiple processing steps with expensive manufacturing equipment, which makes the manufacturing process complicated and increases the manufacturing cost. Furthermore, the disclosed technique is not enough to provide a smooth surface of the lens, which has been evidenced by the scanning electron microscope (SEM) photo in the disclosure.

Wet chemical etching applicable to a semiconductor device manufacturing process is roughly classified into reaction-limited etching and diffusion-limited etching. Reaction-limited etching refers to a type of wet etching based on the chemical reaction itself between a chemical solution and a semiconductor substrate, to which most forms of wet etching performed in common semiconductor processing belong. The chemical reaction depends on the type of material used for the substrate and the composition of chemical solution selected, and thus the etching process can be appropriated controlled by varying these two factors.

Diffusion-limited etching, tie use of which is limited only to a specific structure, not for common semiconductor manufacturing processes, is based on diffusion of an etchant. A typical example of the chemical solution for this diffusion-limited etching is an aqueous bromide (Br₂) solution. This solution has no etching selectivity with respect to a target to be etched and unconditionally collides the surface of exposed semiconductor substrate by diffusion. Because of the etching principle based on the diffusion of bromine, the etching rate increases in the area where a large amount of bromine is provided by active diffusion of bromine. Meanwhile, in the area where the diffusion activity of bromine is relatively low and a small amount of bromine exists, the etching rate decreases. These etching properties of bromine have hindered the application of the diffusion-limited etching to the manufacture of semiconductor devices.

On the other hand, vertical cavity surface emitting lasers (VCSELs), which emit a light beam through a semiconductor material stack, are easy to combine with another optical element and can be easily assembled into an apparatus, and can also be constructed to have a two-dimensional array, and thus VCSELs have wide applications. For example, the VCSEL can be used as a light source in optical transmission systems, such as optical communications or interfacing using optical signals, and as a light source for optical heads in recording/reproducing apparatus.

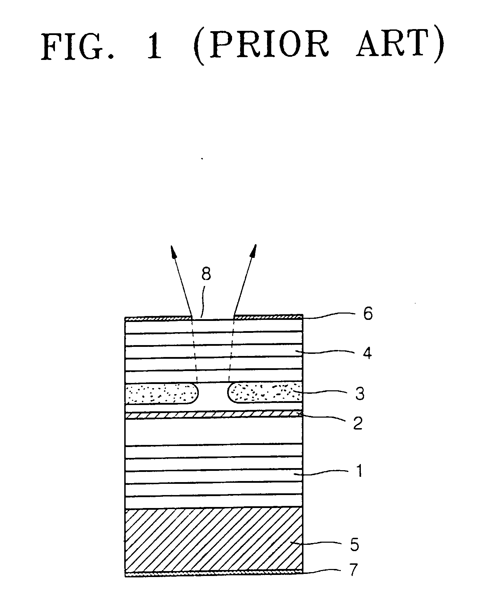

Referring to Figure 1, a conventional VCSEL comprises a substrate 5; a lower reflector 1, an active layer 2, a high-resistance region 3 and an upper reflector 4 sequentially stacked on the substrate 5; an upper electrode 6 formed on a portion of the upper reflector 4, exclusive of a window 8 through which a laser beam is emitted; and a lower electrode 7 formed underneath the substrate 5.

Each of the lower reflector 1 and the upper reflector 4 is a distributed Bragg reflector (DBR) which is a stack of semiconductor material layers having different refractive indexes, but has an opposite conductivity type. For example, the substrate 5 and the lower reflector 1 are doped with the same type of impurity, for example, n-type, and the upper reflector 4 is doped with the other kind of impurity, for example, p-type.

The high-resistance region 3 guides flow of current passed through the upper electrode 6 and lower electrode 7 into the center of the active layer 2. The active layer 2 is a region where light is generated by combination of holes and electrons from the upper and lower reflectors 4 and 1, which is induced by current applied from the upper and lower electrodes 6 and 7.

Light generated in the active layer 2 is reflected repeatedly between the upper and lower reflectors 4 and 1 and only a light beam having a wavelength in accordance with the resonance condition remains, and emitted through the window 8.

However, in the conventional VCSEL having the aforementioned structure, the laser beam emitted through the window 8 has a predetermined radiation angle due to the small size of the window 8, so that a condensing lens is required for condensing the divergent light from the VCSEL. For example, when such a conventional VCSEL is adopted as a light source for an optical transmission system with an optical cable, a condensing lens for condensing a divergent beam is required between the VCSEL and the input terminal of the optical cable, for efficient optical coupling therebetween.

As another example, the conventional VCSEL can be adopted as a light source for an optical head in a recording/reproducing apparatus, which records/reproduces information on/from a recording medium, such as an optical disc, in a non-contact manner. In this case, such a condensing lens for condensing divergent light from the VCSEL is also required.

Briefly, since the conventional VCSEL emits the divergent light through a window, a separated condensing lens for enhancing optical coupling efficiency between a VCSEL and an optical element is required. Also, the condensing lens must be aligned with the central optical axis of the laser beam from the VCSEL by additional steps, which results in a complicated assembly process.

An aim of the present invention is to provide a micro-lens addressing the problems of the prior art as described above or otherwise. Another aim of the present invention is to provide a simple method for manufacturing a high-quality micro-lens.

Yet another aim of the present invention is to provide a combination micro-lens and vertical cavity surface emitting laser (VCSEL) and a method for manufacturing the same, whereby a separate condensing lens and additional steps for aligning the condensing lens with the optical axis of a laser beam from the VCSEL are not required.

In one aspect of the present invention there is provided a micro-lens comprising: a lens body member; and a micro-lens surface having a curvature, formed by etching the lens body member to have convex surface by diffusion-limited etching using an etching mask having an opening exposing a portion of the lens body to be the micro-lens.

Also according to the present invention there is provided a method for manufacturing a micro-lens comprising: forming an etching mask having an opening exposing a portion of a lens body meter to be the micro-lens, on the lens body member; preparing a chemical etching solution containing an etchant causing diffusion-limited etching to the lens body meter; and etching the lens body meter in the chemical etching solution such that the surface of the lens body meter exposed by the opening of the etching mask becomes convex.

Preferably, the lens body member is formed of at least one semiconductor material selected from the group consisting of silicon and a III-V compound including indium phosphide, gallium arsenide, indium arsenide, gallium phosphide, indium gallium phosphide, indium gallium arsenide and aluminum gallium arsenide.

Preferably, the diffusion-limited etching is achieved by diffusion of bromide, and the chemical etching solution is a bromine solution diluted with deionized water, a mixture of hydrogen bromide solution, deionized water and hydrogen peroxide water, or a mixture of hydrogen bromide solution, deionized water, and an acid.

Also, the chemical etching solution preferably contains a solvent having a higher viscosity than water to retard diffusion of etchant contained therein, which allows for easy etching control. For example, the chemical etching solution may be a mixture of bromine and glycerine, a mixture of hydrogen bromide solution, glycerine and hydrogen peroxide water, or a mixture of hydrogen bromide solution, glycerine and an acid.

According to a second aspect of the present invention there is provided a combination micro-lens and VCSEL, in which a laser beam generated through a VCSEL is condensed and emitted through a micro-lens, comprising: a substrate; a lower reflector formed on the substrate, the lower reflector having a relatively high reflectivity; an active layer formed on the lower reflector, for generating a light beam by combination of electrons and holes; an upper reflector formed on the active layer, the upper reflective layer having a relatively lower reflectivity than the lower reflector; a lens layer having the micro-lens with a curvature, formed by depositing a laser-transmitting material on the upper reflector and etching a window region at the lens layer through which the light beam is emitted, to have the surface curvature by diffusion-limited etching; an upper electrode formed on the portion of the lens layer, exclusive of the window region of the lens layer; and a lower electrode formed underneath the substrate.

Also according to the present invention there is provided a combination micro-lens and VCSEL, in which a laser beam generated through a VCSEL is condensed and emitted through a micro-lens, comprises: a substrate having the micro-lens with a curvature, formed of a laser-transmitting material and a window region of substrate through which the light beam is emitted, being etched to have the surface curvature by diffusion-limited etching; a lower reflector formed on the substrate, the lower reflector having a relatively low reflectivity; an active layer formed on the lower reflector, for generating a light beam by combination of electrons and holes; an upper reflector formed on the active layer, the upper reflective layer having a relatively higher reflectivity than the lower reflector; an upper electrode formed on the upper reflector; and a lower electrode formed on the bottom portion of the substrate, exclusive of the window region of the substrate.

Preferably, the lens layer or the substrate is formed of a non-laser absorbing material having a wider bandgap than the wavelength of the output laser beam, and the material is at least one selected from the group consisting of silicon and a III-V compound including indium phosphide, gallium arsenide, indium arsenide, gallium phosphide, indium gallium phosphide, indium gallium arsenide and aluminum gallium arsenide.

Further, according to the present invention there is provided a method for manufacturing a combination micro-lens and VCSEL, comprising: preparing a substrate; forming a low reflector on the substrate to have a relatively high reflectivity; forming an active layer for generating a light beam by combination of electrons and holes, on the lower reflector; forming a lens layer of a laser-transmitting material on the upper reflector; forming an etching mask on the lens layer, the etching mask having an opening exposing a window region of the lens layer to be a micro-lens; preparing a chemical etching solution containing an etchant causing diffusion-limited etching to the lens layer; etching the window region of the lens layer exposed by the opening of the etching mask in the chemical etching solution into the micro-lens with convex curvature by diffusion of the etchant; removing the etching mask; and forming an upper electrode on the portion of the lens layer, exclusive of the window region, and a lower electrode underneath the substrate.

Further still, according to the present invention there is provided a method for manufacturing a combination micro-lens and VCSEL according to the present invention comprises: preparing a substrate formed of a laser-transmitting material; forming a low reflector on the substrate to have a relatively low reflectivity; forming an active layer for generating a light beam by combination of electrons and holes, on the lower reflector; forming an upper reflector on the active layer to have a relatively higher reflectivity than the low reflector; forming an etching mask underneath the substrate, the etching mask having an opening exposing a window region of the substrate to be a micro-lens; preparing a chemical etching solution containing an etchant causing diffusion-limited etching to the substrate; etching the window region of the substrate exposed by the opening of the etching mask in the chemical etching solution into the micro-lens with convex curvature by diffusion of the etchant; removing the etching mask; and forming an upper electrode on the surface of the upper reflector, and a lower electrode on the bottom portion of the substrate, exclusive of the window region.

Preferably, the chemical etching solution is a bromine solution diluted with deionized water, a mixture of hydrogen bromide solution, deionized water and hydrogen peroxide water, or a mixture of hydrogen bromide solution, deionized water, and an acid. The solvent in the chemical etching solution may be water, or solvent having a higher viscosity than water, for example, glycerine, to retard diffusion of etchant contained therein.

For a better understanding of the invention, and to show how embodiments of the same may be carried into effect, reference will now be made, by way of example, to the accompanying diagrammatic drawings in which:
Figure 1 is a sectional view of an example of a conventional vertical cavity surface emitting laser (VCSEL);
Figures 2 and 3 are diagrams illustrating a micro-lens and a method for manufacturing the micro-lens according to an embodiment of the present invention;
Figure 4 illustrates the profile of an example of the micro-lens;
Figure 5 is a diagram for illustrating the principle of etching a lens body member into a micro-lens having a convex surface by diffusion of an etchant, using an etching mask;
Figure 6 is a sectional view illustrating a combination micro-lens and VCSEL according to a preferred embodiment of the present invention; and
Figure 7 is a diagram illustrating another combination micro-lens and VCSEL according to the preferred embodiment of the present invention.

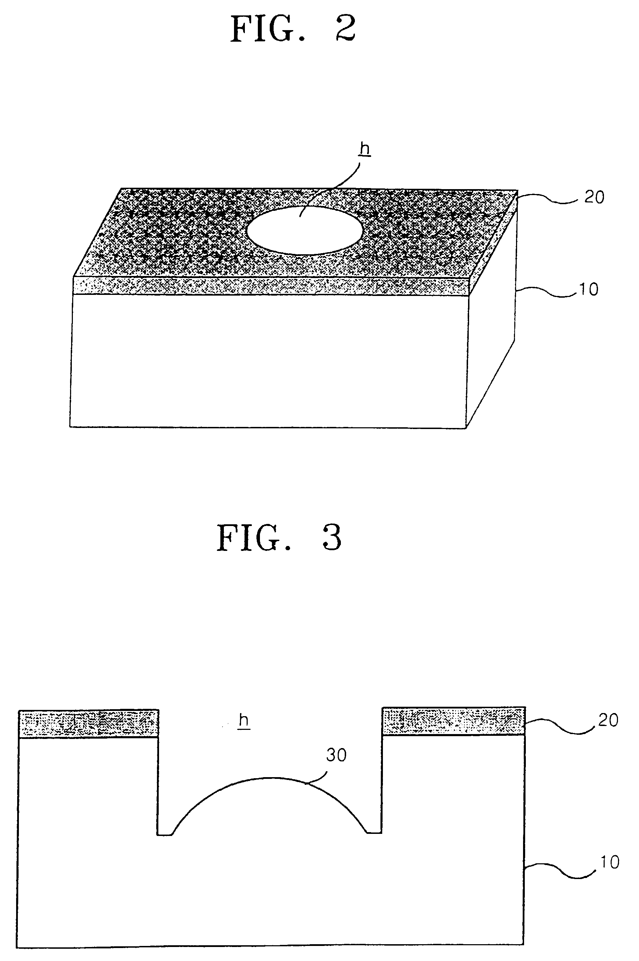

Referring to Figures 2 and 3, a micro-lens according to a preferred embodiment of the present invention includes a semiconductor member 10, which forms the body of the lens, and a micro-lens curvature portion 30 formed by etching a portion of the semiconductor member 10 exposed through an opening "h" of an etching mask put on the semiconductor member 10 to have a convex surface with curvature by diffusion-limited etching.

The semiconductor member 10 is formed of at least one semiconductor material selected from the group consisting of silicon, and a III-V compound including indium phosphide (InP), gallium arsenide (GaAs), indium arsenide (InAs), gallium phosphide (GaP), indium gallium phosphide (InGaP), indium gallium arsenide (InGaAs) and aluminum gallium arsenide (AlGaAs).

Figure 2 illustrates a state in which the etching mask 20 has been formed on the semiconductor member 10. For the structure of Figure 2, on a lens forming surface of the semiconductor meter 10, a dielectric layer such as a silicon nitride layer or a silicon oxide layer is initially deposited to a predetermined thickness, for example, to a thickness of about 100 nm.

Following this, a photoresist layer is coated on the dielectric layer and subjected to a photolithography process to expose a region to be a micro-lens. Then, the exposed portion of the dielectric layer is etched by reactive ion etching (RIE) and the photoresist layer is removed, which results in the etching mask 20 having the opening "h".

The etching mask 20 may be formed of photoresist alone, but preferably the aforementioned dielectric layer may be used in the formation of the etching mask 20 so as to prevent an etching bath from contamination by the photoresist during a subsequent wet etching process. In addition, the etching mask 20 may be formed of a metal substance.

The diameter of the opening "h" may be on the order of several micrometers to several hundred micrometers to be equal to the size of micro-lens to be formed. Figure 2 illustrates an example of a circular opening "h" for a spherical micro-lens, however, the shape of opening "h" may be varied depending to the shape of the intended micro-lens. For example, the opening "h" may be formed as a slit for a cylindrical micro-lens. In addition, a plurality of openings may be formed for a micro-lens array.

Next, a chemical etching solution containing an appropriate concentration of etchant, which is capable of inducing diffusion-limited etching to the semiconductor member 10, is prepared. The etchant may be bromine. When bromine is used as the etchant, diffusion-limited etching is achieved by diffusion of bromine.

For dilution of the chemical etching solution, deionized water is used. The chemical etching solution which is diluted with deionized water may include a bromine (Br₂) solution diluted with deionized water, a mixture of hydrogen bromide (HBr) solution, deionized water and hydrogen peroxide (H₂O₂) water, and a mixture of HBr solution, deionized water, and an acid such as nitric acid (HNO₃). The hydrogen bromide solution means an aqueous hydrogen bromide, i.e., hydrobromic acid (HBr·H₂O). However, the hydrogen bromide solution may be prepared by dissolving hydrogen bromide in solvents other than deionized water.

When a chemical etching solution containing bromine is prepared by reacting a hydrogen bromide solution with a reactive solution such as H₂O₂ water or acid, it is preferable that the hydrogen bromide solution is diluted with deionized water prior to the addition of the reactive solution, such that the reaction between the hydrogen bromide solution and the reactive solution takes place at a proper rate.

Since the present invention relates to wet etching based on diffusion of the etchant contained in a chemical etching solution, it is desirable to retard the diffusion of the etchant for easy etching control. To this end, a solvent having a higher viscosity than deionized water, for example, glycerine, may be used as a diluent.

The chemical etching solution containing glycerine as a solvent may be a mixture of bromine (Br₂) and glycerine, a mixture of hydrogen bromide solution, glycerine and H₂O₂ water, or a mixture of hydrogen bromide solution, glycerine and an acid.

After the preparation of the chemical etching solution, the semiconductor member 10 with the etching mask 20 is immersed in the chemical etching solution for a predetermined period of time, for example, for several minutes to several tens of minutes, which allows the etchant to etch the exposed portion of the semiconductor member 10 through the opening "h" into the micro-lens 30 having convex surface, as shown in Figure 3. The convex surface of the micro lens 30 is caused by a spatial etching rate difference by diffusion of bromine.

During the etching process, the chemical etching solution with the semiconductor member 10 is left for reaction without agitation. The curvature of the micro-lens 30 is defined by the concentration of chemical etching solution and the reaction time.

After the micro-lens 30 has been completed, the dielectric layer used as the etching mask 20 may be removed in certain cases.

In an experiment conducted by the instant inventors, an etching mask was formed on an InP semiconductor member by depositing a silicon nitride layer to a thickness of about 100 nm, and the structure was etched in a chemical etching solution for a few minutes, for example, 5 minutes, to form a micro-lens. For preparation of the chemical etching solution, 20 ml of hydrobromic acid (HBr·H₂O, in a concentration of about 48-50%) was diluted with 200 ml of deionized water, and reacted with 10 ml of H₂O₂ water (in a concentration of about 34.02%) for 10 minutes. Then, 400 ml of deionized water was added to the mixture. Here, the composition of the chemical etching solution may be varied.

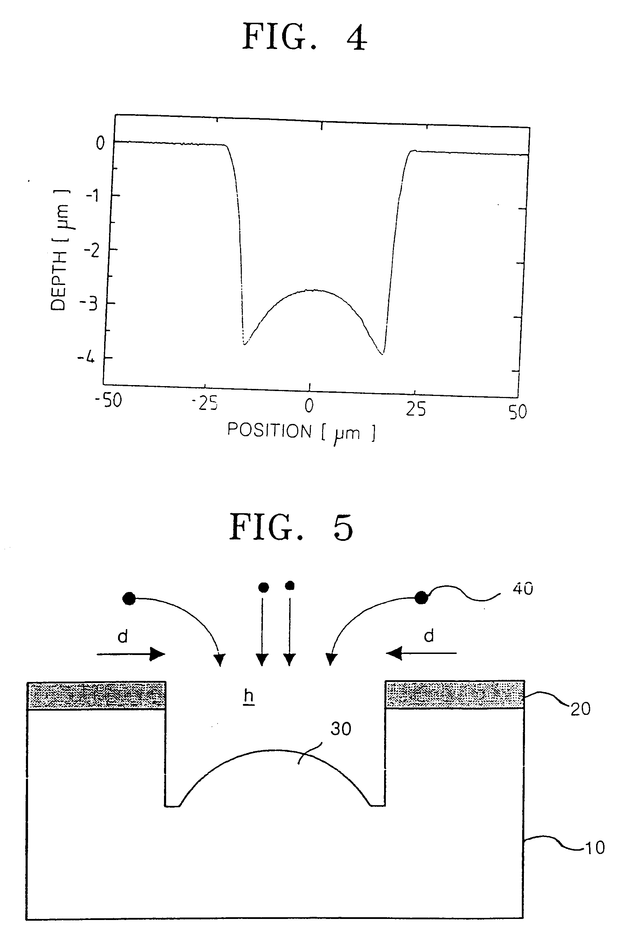

The profile of the micro-lens obtained in the experiment was measured by Alpha Step 500, which is used to measure topology characteristics in semiconductor device manufacturing processes, and the result is shown in Figure 4. As shown in Figure 4, it should be noted that the micro-lens has a smooth convex surface.

Hereinafter, the principle of etching the exposed surface of the semiconductor member 10 through the opening "h" into the convex micro-lens 30 by diffusion of an etchant 40 will now be described with reference to Figure 5.

As the semiconductor member 10 with the etching mask 20 is immersed in a chemical etching solution containing the etchant 40, bromine seeking a target to etch, enters the opening "h" of the etching mask 20 by diffusion, and reaches the exposed surface of the semiconductor member 10. Because it is more likely that bromine is consumed by etching the edge of the exposed surface of the semiconductor member 10 before reaching the center of the exposed surface of the semiconductor member 10, the etching depth to the semiconductor member 10 is deeper at the edge than at the center of the exposed surface of the semiconductor member 10. In other words, the etching depth decreases in the direction indicated by arrows "d", reaching a minimal level at the center of the exposed semiconductor member 10, which results in the micro-lens 30 with convex curvature on the semiconductor member 10.

For control of the diffusion rate of the etchant 40, i.e., bromine, during the etching process, deionized water in addition to a solvent having a higher viscosity than deionized water, such as glycerine, may be used as a solvent for a chemical etching solution containing bromine.

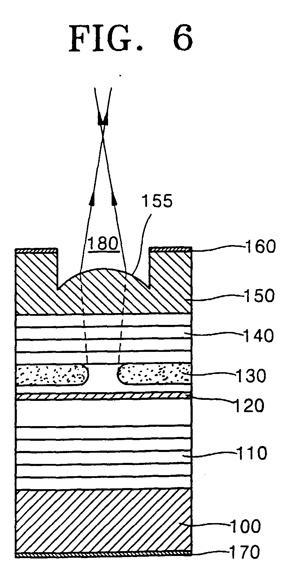

Figure 6 is a sectional view illustrating a preferred embodiment of a combination micro-lens and VCSEL according to the present invention. Referring to Figure 6, the combination micro-lens and VCSEL includes a substrate 100; a lower reflector 100, an active layer 120, an upper reflector 140 and a lens layer 150 which are sequentially stacked on the substrate 100; an upper electrode 160 formed on the portion of the lens layer 150, exclusive of a window region 180 thereof through which a laser beam is emitted; and a lower electrode 170 formed underneath the substrate 100.

The substrate 100 may be formed of a semiconductor material, such as n-doped GaAs, AlGaAs, InAs, InP, GaP, InGaP, InGaAs or GaP.

Each of the lower reflector 110 and the upper reflector 140 is formed by alternating semiconductor compounds having different refractive indexes, and is doped with different types of impurity.

For the structure shown in Figure 6, in which most of the laser beam is emitted through the upper reflector 140, the upper reflector 140 is formed to have a relatively lower reflectivity compared to that of the lower reflector 110. The reflectivity of reflectors varies depending on the number of semiconductor compound layers deposited to form the same. Accordingly, by forming the upper reflector 140 with material layers less than those for the lower reflector 110, the reflectivity of the upper reflector 140 can be lower than that of the lower reflector 110.

For the aforementioned structure, if the substrate is doped with n-type impurities, the lower reflector 110 may be doped with the same n-type impurities but the upper reflector 140 is doped with p-type impurities.

The upper and lower reflectors 140 and 110 induce flow of electrons and holes by the current applied through the upper and lower electrodes 160 and 170, which allows the active layer 120 to generate a laser beam, and reflect repeatedly the laser beam generated in the active region 120, and thus only a laser beam in accordance to the resonance conditions emits through the upper reflector 140.

The active layer 120, a region where a laser beam is generated by energy transition due to the combination of holes and electrons provided through the upper and lower reflectors 140 and 110, has a single or multiple quantum-well structure or super lattice structure. The active layer 120 may be formed of, for example, GaAs, AlGaAs, InGaAs, InGaP and/or AlGaAsP according to the wavelength of output laser beam.

Preferably, a high-resistance region 130 is interposed between the active layer 120 and the upper reflector 140, which is for guiding flow of current applied through the upper electrode 160 into the center of the active layer 120 for generation of light. The high-resistance region 130 shown in Figure 6 is formed by implantation with ions such as protons. The high-resistance region 130 may be formed by selective oxidation. In the selective oxidation, a pre-oxidative layer (not shown) is deposited and exposed in an oxygen atmosphere, which results in an insulating oxide layer as a high-resistance region, at the exposed portion of the pre-oxidative layer.

The lens layer 150, which corresponds to the semiconductor member 10 of the micro-lens in Figure 2, is formed on the upper reflector 140 to have a predetermined thickness, for example, a thickness of several micrometers. Preferably, the lens layer 150 is formed of a compound semiconductor material capable of lattice matching with material used for the upper reflector 140, and having a relatively wide bandgap to the wavelength of the laser beam generated from the VCSEL, so as not to absorb, but just transmit the laser beam through the upper reflector 140.

For example, if the VCSEL is designed to emit a laser beam having a wavelength of about 500 to 900 nm, the lens layer 150 may be formed of InGaP. Here, the composition ratio of In and Ga may be varied according to the wavelength of the desired output laser beam, which has a wavelength of, for example, 850 nm, 780 nm or 660 nm.

Alternatively, if the VCSEL is designed to emit a laser beam having a wavelength of about 980 nm, the lens layer 150 may be formed of GaAs.

In addition, according to the wavelength of the output laser beam from the VCSEL, the lens layer 150 may be formed of at least one semiconductor material selected from silicon and a III-V compound including InP, GaAs, InAs, GaP, InGaP and InGaAs.

The lens layer 150 has a micro-lens 155 with convex surface in its window region 180 through which the laser beam is emitted. The laser beam through the lens layer 150 is condensed by a micro-lens 155 and emitted through the window region 180.

In the combination micro-lens and VCSEL according to the present invention, the focal length of the output condensed beam is determined according to the curvature of the micro-lens 155 and the thickness of the lens layer 150.

The upper electrode 160 is formed on the portion of the lens layer 150, exclusive of the window portion180 thereof, and the lower electrode 170 is formed underneath the substrate 100.

When a forward biased current is applied to the combination micro-lens and VCSEL according to the present embodiment of the present invention through the upper and lower electrodes 160 and 170, the current is guided into the center of the active layer 120 by the high-resistance region 130, and electrons and holes from the upper and lower reflectors 140 and 110 combine to generate a light beam in the active layer 120. The generated light beam is reflected repeatedly between the upper and lower reflectors 140 and 110 and thus only a light beam having a particular wavelength in accordance with the resonance conditions remains and transmits the upper reflector 140. The light beam passed through the upper reflector 140 is condensed by the micro-lens 155 while passing the lens layer 150, and then emitted.

Thus, the combination micro-lens and VCSEL according to the present invention eliminates the need for optical axis alignment with respect to a separate condensing lens, which is required in the conventional VCSEL for combination with the separate condensing lens. Thus, the combination micro-lens and VCSEL according to the present invention ensures efficient coupling between the laser beam from the VCSEL and the optical element of an optical system such as an optical transmission system or an optical head for a recording/playback apparatus. The optical transmission system is suitably a system which provides optical communications via an optical cable and interfaces using optical signals.

When the combination micro-lens and VCSEL according to the present invention is adopted for interfacing using optical signals within undefined space, the degree of freedom in arrangement of optical transmitting and receiving portions increases and a photodetector having a relatively small light receiving area can be adopted, which allows for rapid optical signal transmission and reception. Also, the combination micro-lens and VCSEL according to the present invention can be constructed in an array including or excluding a photodetector in a more compact structure.

Hereinafter, a method for manufacturing a combination micro-lens and VCSEL according to a preferred embodiment of the present invention will now be described. Initially, the substrate 100 is prepared. Next, the lower reflector 110 having a relatively high reflectivity, the active layer 120 for producing a light beam by electron/hole pairs, the upper reflector 140 having a relatively low reflectivity, and the lens layer 150 formed of a non-laser absorbing material to have, for example, a thickness of several micrometers, are sequentially stacked on the substrate 100, which results in the basic frame of the surface emitting laser shown in Figure 6.

Following this, an etching mask is formed having an opening which defines the shape of the micro-lens 155 to be formed on the lens layer 150. For the formation of the etching mask, an etching mask layer is deposited on the lens layer 150, and partially etched to form the opening exposing the window region 180 of the lens layer 150.

The diameter of the opening varies from several micrometers to several hundred micrometers to be equal to the size of the desired micro-lens 155. In addition, the shape of the opening varies depending on the shape of the micro-lens 155, and further depending on the shape of the window region 180.

In the case of manufacturing a combination micro-lens and VCSEL array, the number of openings can be increased according to the desired VCSEL array structure.

The etching mask with the opening is substantially the same as that in Figures 2 and 3, which have been referred to describe the formation of the micro-lens, and thus an illustration and description thereof will not be repeated.

Thereafter, a chemical etching solution containing an appropriate concentration of etchant capable of etching the lens layer 150 by diffusion-limited etching is prepared. The structure with the etching mask is immersed in the chemical etching solution for a predetermined period of time, for example, for several minutes to several tens of minutes, which allows the etchant to etch the exposed surface of the lens layer 150, resulting in the micro-lens 155 having a convex surface.

The usable chemical etching solution and the principle of etching the lens layer 150 through the opening into the convex micro-lens 155 by diffusion of etchant of the chemical etching solution is substantially the same as those described with reference to Figures 2 through 5, and thus a detailed description thereof will not be repeated.

After the micro-lens 155 having a desired curvature has been formed at the lens layer 150 using the chemical etching solution, the etching mask is removed by, for example, reactive ion etching (RIE).

Then, the upper electrode 160 is formed on the portion of the lens layer 150, exclusive of the window region 180 having the micro-lens 155, and the lower electrode 170 is formed underneath the substrate 100, so that the combination micro-lens and VCSEL according to the present invention shown in Figure 6 is completed.

In the foregoing embodiment, if an etching mask formed of a metal is used, the etching mask need not be removed such that it can serve as a base layer for the upper electrode 160 or as the upper electrode 160 itself.

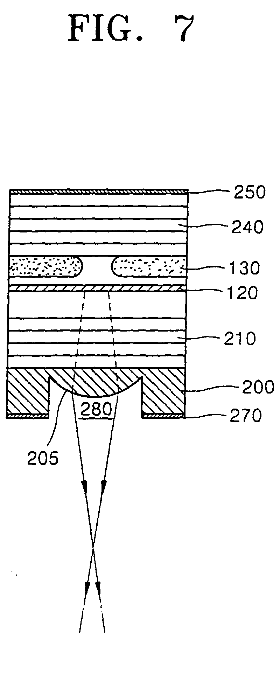

Figure 7 is a sectional view illustrating another preferred embodiment of the combination micro-lens and VCSEL according to the present invention, wherein like reference numerals have been retained if or elements having the same function and structure as those of Figure 6. Referring to Figure 7, the combination micro-lens and VCSEL includes a substrate 200 having a window region 280, which is formed of a material capable of transmitting a laser beam having a desired wavelength; a lower reflector 200, the active layer 120 and an upper reflector 240 which are sequentially stacked on the substrate 200; an upper electrode 260 formed on the upper reflector 240; and a lower electrode 270 formed underneath the portion of the substrate 200, exclusive of the window region 280 through which the laser beam is emitted. As shown in Figure 7, the combination micro-lens and VCSEL according to this embodiment of the present invention is characterized in that the laser beam is emitted through the substrate 200.

For the structure having the foregoing feature, the lower reflector 210 is formed to have a lower reflectivity than the upper reflector 240. For example, by forming the lower reflector 210 to include fewer layers than those for the upper reflector 240, the lower reflector 210 having a relatively low reflectivity compared to that of the upper reflector 240 can be formed, which allows the lower reflector 210 to transmit most of the laser beam. The material used to form the upper and lower reflectors 240 and 210, and the stack structure thereof are the same as those illustrated with reference to Figure 6, and thus a detailed description thereof will not be repeated.

Similar to the lens layer 150 shown in Figure 6, preferably, the substrate 200, through which the laser beam from the lower reflector 210 is emitted, is formed of a material having a wider bandgap than the wavelength of the output laser beam, such that absorption of the laser beam by the substrate 200 almost does not occur.

A micro-lens 205 is formed in the window region 280 of the substrate 200 through which the laser beam is emitted. The principle of forming the micro-lens 205 in the substrate 200 by diffusion-limited etching is substantially the same as in the micro-lens formation illustrated with reference to Figures 2 through 5, and thus a detailed description thereof will not be repeated.

When a forward biased current is applied to the combination micro-lens and VCSEL shown in Figure 7 through the upper and lower electrodes 260 and 270, a current is guided into the center of the active layer 120 by the high-resistance region 130, and electrons and holes from the upper and lower reflectors 240 and 210 combine to generate a light beam in the active layer 120. The generated light beam is reflected repeatedly between the upper and lower reflectors 240 and 210 and only a light beam having a particular wavelength in accordance with the resonance conditions remains and transmits the lower reflector 210. The light beam passed through the lower reflector 210 is condensed by the micro-lens 205 while passing the substrate 200, and then emitted.

Another embodiment of the method for manufacturing the combination micro-lens and VCSEL shown in Figure 7 will now be described. Initially, the substrate 200 formed of a material that does not absorb a laser beam having a desired wavelength is prepared. Next, the lower reflector 210 having a relatively low reflectivity, the active layer 120, and the upper reflector 240 having a relatively higher reflectivity than the lower reflector 210 are sequentially stacked on the substrate 200, which results in the basic frame of the surface emitting laser shown in Figure 7.

Following this, the micro-lens forming process illustrated with reference to Figures 2 through 5 is applied to form the micro-lens 205 having convex surface on the bottom of the substrate 200 by etching the window region 280 of the substrate 200 by diffusion of etchant.

Then, the upper electrode 260 is formed on the upper reflector 240 and the lower electrode 270 is formed at the bottom portion of the substrate 200, exclusive of the window region 280 having the micro lens 205, so that the combination micro-lens and VCSEL according to Figure 7 is completed.

As described above, the high-quality micro-lens according to the present invention can be manufactured by simple diffusion-limited etching. Also, the combination micro-lens and VCSEL according to the present invention, in which the micro-lens for condensing output laser beam is formed at a light emitting surface of a VCSEL, can eliminate the need for alignment of a separate condensing lens with the optical axis of the output laser beam.

Thus, the combination micro-lens and VCSEL according to the present invention can be applied to optical systems such as optical transmission systems and optical heads for recording/playback apparatuses, without additional steps for alignment of optical axis, thereby reducing the optical system building cost.

While this invention has been particularly shown and described with reference to preferred embodiments thereof, it will be understood by those skilled in the art that various changes in form and details may be made therein without departing from the and scope of the invention as defined by the appended claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extend to any novel one, or any novel combination, of the features disclosed in this specification (including any accompanying claims, abstract and drawings), or to any novel one, or any novel combination, of the steps of any method or process so disclosed.

## Claims

1. A micro-lens comprising:
a lens body member (10); and
a micro-lens surface (30) having a curvature, formed by etching the lens body member (10) to have convex surface by diffusion-limited etching using an etching mask (20) having an opening exposing a portion of the lens body to be the micro-lens.

2. The micro-lens of claim 1, wherein the lens body member (10) is formed of at least one semiconductor material selected from the group consisting of silicon and a III-V compound including indium phosphide, gallium arsenide, indium arsenide, gallium phosphide, indium gallium phosphide, indium gallium arsenide and aluminum gallium arsenide.

3. A method for manufacturing a micro-lens comprising:
forming an etching mask (20) having an opening (h) exposing a portion of a lens body member (10) to be the micro-lens, on the lens body member (10);
preparing a chemical etching solution containing an etchant causing diffusion-limited etching to the lens body member (10); and
etching the lens body member (10) in the chemical etching solution such that the surface of the lens body member (10) exposed by the opening (h) of the etching mask (20) becomes convex.

4. The method of claim 3, wherein the lens body member (10) is formed of at least one semiconductor material selected from the group consisting of silicon and a III-V compound including indium phosphide, gallium arsenide, indium arsenide, gallium phosphide, indium gallium phosphide, indium gallium arsenide and aluminum gallium arsenide.

5. The method of claim 3 or 4, wherein the diffusion-limited etching is achieved by diffusion of bromide.

6. The method of claim 5, wherein the chemical etching solution is one selected from the group consisting of a bromine solution diluted with deionized water, a mixture of hydrogen bromide solution, deionized water and hydrogen peroxide water, and a mixture of hydrogen bromide solution, deionized water, and an acid.

7. The method of any of claims 3 to 5, wherein the chemical etching solution contains a solvent having a higher viscosity than water to retard diffusion of etchant contained therein.

8. The method of claim 7, wherein the chemical etching solution is one selected from the group consisting of a mixture of bromine and glycerine, a mixture of hydrogen bromide solution, glycerine and hydrogen peroxide water, and a mixture of hydrogen bromide solution, glycerine and an acid.

9. The method of claim 6 or 8, wherein the acid is nitric acid.

10. A combination micro-lens and vertical cavity surface emitting laser (VCSEL), in which a laser beam generated through a VCSEL is condensed and emitted through a micro-lens, comprising:
a substrate (100);
a lower reflector (110) formed on the substrate, the lower reflector having a relatively high reflectivity;
an active layer (120) formed on the lower reflector (110), for generating a light beam by combination of electrons and holes;
an upper reflector (140) formed on the active layer (120), the upper reflective layer having a relatively lower reflectivity than the lower reflector;
a lens layer (150) having the micro-lens (180) with a curvature, formed by depositing a laser-transmitting material on the upper reflector (140) and etching a window region of the lens layer through which the light beam is emitted, to have the surface curvature by diffusion-limited etching;
an upper electrode (160) formed on the portion of the lens layer (150), exclusive of the window region of the lens layer; and
a lower electrode (170) formed underneath the substrate (100).

11. The combination micro-lens and VCSEL of claim 10, wherein the lens layer (150) is formed of a non-laser absorbing material having a wider bandgap than the wavelength of the output laser beam, and the material is at least one selected from the group consisting of silicon and a III-V compound including indium phosphide, gallium arsenide, indium arsenide, gallium phosphide, indium gallium phosphide, indium gallium arsenide and aluminum gallium arsenide.

12. A combination micro-lens and vertical cavity surface emitting laser (VCSEL), in which a laser beam generated through a VCSEL is condensed and emitted through a micro-lens, comprising:
a substrate (200) having the micro-lens (270) with a curvature, formed of a laser-transmitting material and a window region of substrate through which the light beam is emitted, being etched to have the surface curvature by diffusion-limited etching;
a lower reflector (210) formed on the substrate, the lower reflector having a relatively low reflectivity;
an active layer (120) formed on the lower reflector, for generating a light beam by combination of electrons and holes;
an upper reflector (240) formed on the active layer, the upper reflective layer having a relatively higher reflectivity than the lower reflector;
an upper electrode (250) formed on the upper reflector; and
a lower electrode (270) formed on the bottom portion of the substrate, exclusive of the window region of the substrate.

13. The combination micro-lens and VCSEL of claim 14, wherein the substrate (200) is formed of a non-laser absorbing material having a wider bandgap than the wavelength of the output laser beam, and the material is at least one selected from the group consisting of silicon and a III-V compound including indium phosphide, gallium arsenide, indium arsenide, gallium phosphide, indium gallium phosphide, indium gallium arsenide and aluminum gallium arsenide.

14. A method for manufacturing a combination micro-lens and vertical cavity surface emitting laser (VCSEL), comprising:
preparing a substrate (100);
forming a lower reflector (110) on the substrate to have a relatively high reflectivity;
forming an active layer (120) for generating a light beam by combination of electrons and holes, on the lower reflector;
forming a lens layer (150) of a laser-transmitting material on the upper reflector;
forming an etching mask (20) on the lens layer, the etching mask having an opening exposing a window region of the lens layer to be a micro-lens;
preparing a chemical etching solution containing an etchant causing diffusion-limited etching to the lens layer (150);
etching the window region of the lens layer (150) exposed by the opening of the etching mask (20) in the chemical etching solution into the micro-lens with convex curvature by diffusion of the etchant;
removing the etching mask (160); and
forming an upper electrode (160) on the portion of the lens layer, exclusive of the window region, and a lower electrode underneath the substrate.

15. The method of claim 14, wherein the diffusion-limited etching is achieved by diffusion of bromide.

16. The method of claim 15, wherein the chemical etching solution is one selected from the group consisting of a bromine solution diluted with deionized water, a mixture of hydrogen bromide solution, deionized water and hydrogen peroxide water, and a mixture of hydrogen bromide solution, deionized water, and an acid.

17. The method of claim 14, wherein the chemical etching solution contains a solvent having a higher viscosity than water to retard diffusion of etchant contained therein.

18. The method of claim 17, wherein the chemical etching solution is one selected from the group consisting of a mixture of bromine and glycerine, a mixture of hydrogen bromide solution, glycerine and hydrogen peroxide water, and a mixture of hydrogen bromide solution, glycerine and an acid.

19. A method for manufacturing a combination micro-lens and vertical cavity surface emitting laser (VCSEL), comprising:
preparing a substrate (200) formed of a laser-transmitting material;
forming a low reflector (210) on the substrate to have a relatively low reflectivity;
forming an active layer (120) for generating a light beam by combination of electrons and holes, on the lower reflector;
forming an upper reflector (240) on the active layer to have a relatively higher reflectivity than the low reflector;
forming an etching mask (20) underneath the substrate, the etching mask having an opening exposing a window region of the substrate to be a micro-lens;
preparing a chemical etching solution containing an etchant causing diffusion-limited etching to the substrate (200);
etching the window region of the substrate exposed by the opening of the etching mask in the chemical etching solution into the micro-lens with convex curvature by diffusion of the etchant;
removing the etching mask; and
forming an upper electrode (250) on the surface of the upper reflector, and a lower electrode (270) on the bottom portion of the substrate, exclusive of the window region.

20. The method of claim 19, wherein the diffusion-limited etching is achieved by diffusion of bromide.

21. The method of claim 20, wherein the chemical etching solution is one selected from the group consisting of a bromine solution diluted with deionized water, a mixture of hydrogen bromide solution, deionized water and hydrogen peroxide water, and a mixture of hydrogen bromide solution, deionized water, and an acid.

22. The method of claim 19, wherein the chemical etching solution contains a solvent having a higher viscosity than water to retard diffusion of etchant contained therein.

23. The method of claim 22, wherein the chemical etching solution is one selected from the group consisting of a mixture of bromine and glycerine, a mixture of hydrogen bromide solution, glycerine and hydrogen peroxide water, and a mixture of hydrogen bromide solution, glycerine and an acid.
